# EUROPEAN PATENT APPLICATION

(11) **EP 2 088 471 A1**
(43) Date of publication of application: **12.08.2009**
(21) Application number: 08163165.7
(22) Date of filing: 28.08.2008
(51) Int. Cl.: G03G 5/04, G03G 5/06

(54) **Electrophographic Photoreceptor and Electrophotographic Imaging Apparatus Using the Same**

(30) Priority: 11.02.2008 KR 20080012272
(71) Applicant: Samsung Electronics Co., Ltd., Suwon-si, Gyeonggi-do (KR)
(72) Inventor: Kim, Ji-uk, Anyang-si, Gyeonggi-do (KR); Kim, Beom-jun, Jukjeon-dong, Gyeonggi-do (KR)
(74) Representative: Killin, Stephen James

(57) **Abstract**

An electrophotographic photoreceptor and an electrophotographic imaging apparatus using the same, the electrophotographic photoreceptor including a diphenoquinone including an oxadiazolene group represented by Formula 1 below as an electron transporting material in a single-layer type photosensitive layer or in a charge generating layer of a laminated type photosensitive layer: 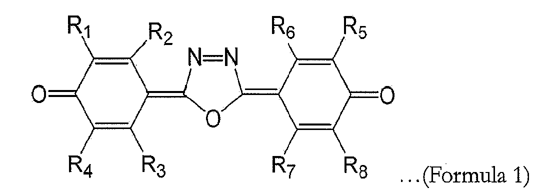 wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group. The electrophotographic photoreceptor has excellent electrical properties, such as high charge potential and high charge potential stability during repetitive use.

## Description

The present invention relates to an electrophotographic photoreceptor and an electrophotographic imaging apparatus using the same, and more particularly, to an electrophotographic photoreceptor including a diphenoquinone-based compound including an oxadiazolene group within a charge-generating layer or a single-layer type photosensitive layer, and thus having excellent electrical properties and stability, and an electrophotographic imaging apparatus using the same.

Electrophotographic devices, such as facsimile machines, laser printers, copying machines, CRT printers, liquid crystal printers, LED printers, large plotters and laser electrophotographs and the like, include an electrophotographic photoreceptor including a photosensitive layer formed on an electrically conductive substrate. The electrophotographic photoreceptor can be in a form of a plate, a disk, a sheet, a belt, a drum, or the like and forms an image as follows. First, a surface of the photosensitive layer is uniformly and electrostatically charged, and then a charged surface is exposed to a pattern of light, thus forming the image. The light exposure selectively dissipates the charge in exposed regions where the light strikes the surface, thereby forming a pattern of charged and uncharged regions, which is referred to as a latent image. Then, a wet or dry toner is provided in a vicinity of the latent image, and toner droplets or particles collect in either the charged or uncharged regions to form a toner image on the surface of the photosensitive layer. A resulting toner image may be transferred to a suitable final or intermediate receiving surface, such as paper, or the photosensitive layer may function as a final receptor for receiving the image. Lastly, a residual electrostatic image on the surface of the photosensitive layer is removed by radiating light, emitted from an eraser lamp, on the surface of the photosensitive layer uniformly. Then, a small amount of residual toner left on the surface of the photosensitive layer is removed by using mechanical components such as a brush or blade.

Electrophotographic photoreceptors are generally categorized into two types. The first is a laminated type electrophotographic photoreceptor having a laminated structure including a charge generating layer (CGL) including a binder resin, a charge generating material (CGM) and, optionally, other additives, and a charge transporting layer (CTL) including a binder resin, a charge transporting material (usually, a hole transporting material (HTM)) and, optionally, other additives. In general, laminated-type electrophotographic photoreceptors constitute negative (-) type electrophotographic photoreceptors. The charge generating layer generates electrical signals from light. The charge transporting layer transfers electrical signals generated from the charge generating layer to the surface of the photoreceptor.

In a conventional laminated type photoreceptor, high sensitivity can be obtained by increasing the content of the CGM within the charge generating layer. If the content of the CGM is relatively high, electrical performance may improve with increased sensitivity and decreased residual potential, but stability of the coating slurry to form the charge generating layer decreases. Accordingly, coating quality of the charge generating layer becomes degraded, and adhesion strengths between the electrically conductive substrate/the charge generating layer and the charge generating layer/the charge transporting layer of the photoreceptor deteriorates. Meanwhile, if the content of the CGM is relatively low, mechanical properties such as the stability of the coating slurry to form the charge generating layer, the coating quality, and the adhesion strengths between the electrically conductive substrate/the charge generating layer, and the charge generating layer/charge transporting layer of the photoreceptor may be improved, but the sensitivity may decrease and a residual potential may increase. If the thickness of the charge generating layer is increased in order to increase the sensitivity, electrons generated from the CGM may not be easily transported to the electrically conductive substrate, and thus the charge generation becomes difficult, thereby decreasing the sensitivity and increasing the residual potential.

A second type is a single-layer type electrophotographic photoreceptor in which a binder resin, a CGM, an HTM, and an electron transporting material (ETM) are included in a single-layer type photosensitive layer. In general, single-layer type electrophotographic photoreceptors constitute positive (+) type electrophotographic photoreceptors. Japanese Patent Laid-Open Publication Nos. 2000-147806, 2000-330306, 2002-221809, and 2000-199979 disclose single-layer type photoreceptors including CGM, HTM, and electron transport material (ETM) formed on an electrically conductive substrate. However, although the single-layer type photoreceptors disclosed in the patent publications above have relatively good electrical properties, the stability of the coating slurry to form the single-layer type photoreceptors, the decreased adhesion strength and the like still leave room for improvement.

U.S. Patents Nos. 5,547,790, 5,677,094, and 5,571,648 attempt to improve the electrical properties by adding a polymeric CTM, particularly a polymeric HTM, on the charge generating layer, the intermediate layer, or the protective layer, but there is still a great demand for an electrophotographic photoreceptor with improved electrical properties. Specific examples of conventionally used ETM include electron-accepting materials such as dicyanofluorenone-based compounds, benzoquinone-based compounds, cyanoethylene-based compounds, cyanoquinodimethane-based compounds, fluorene-based compounds, xanthone-based compounds, anhydrous phthalate-based compounds, thiopyran-based compounds, thiophenoquinone-based compounds, and stilbenequinone-based compounds. Electron transporting characteristics of such ETMs are generally 100 times worse than hole transporting characteristics of HTMs, and therefore the electrical properties of the photoreceptors are greatly affected by the electron transporting characteristics of the ETM. That is, conventional ETMs have insufficient electron transporting characteristics, and thus when used in preparing a photoreceptor, particularly a single-layer type photoreceptor, during repeated exposure, the charge potential is dramatically decreased, and the residual potential is increased. Therefore, enhancing the electron transporting characteristics is required in order to improve the electrical properties of the photoreceptors.

The present invention provides an electrophotographic photoreceptor with improved electrical properties by including an electron transporting material with improved electron transporting characteristics.

The present invention also provides an electrophotographic imaging apparatus including the electrophotographic photoreceptor.

In a first aspect, the present invention provides an electrophotographic photoreceptor including an electrically conductive substrate, a charge generating layer formed on the electrically conductive substrate, wherein the charge generating layer includes a charge generating material (CGM) and an electron transporting material (ETM) having a diphenoquinone-based compound including an oxadiazolene group represented by Formula 1 below, dispersed or dissolved within a binder resin, and a charge transporting layer formed on the charge generating layer, wherein the charge transporting layer includes a charge transporting material (CTM) dispersed or dissolved within a binder resin: 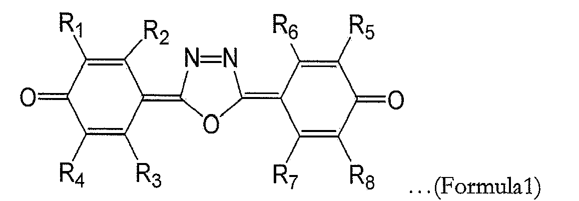 wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

In a second aspect, the present invention provides an electrophotographic photoreceptor including an electrically conductive substrate, and a photosensitive layer formed on the electrically conductive substrate, wherein the photosensitive layer is a charge generating-transporting layer including a CGM, an HTM, and a diphenoquinone-based compound including an oxadiazolene group of Formula 1 below as an ETM, dispersed or dissolved within a binder resin: 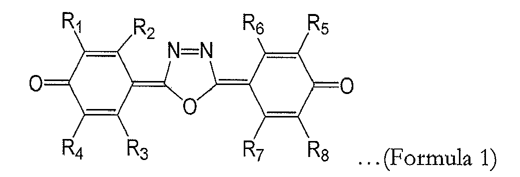 wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

In further aspects, the present invention provides an electrophotographic imaging apparatus including the single-layer type or the laminated type electrophotographic photoreceptor in accordance with the invention in its first or second aspects.

In a further aspect, the present invention provides an electrophotographic photoreceptor for use in an electrophotographic imaging apparatus, the electrophotographic photoreceptor including a photosensitive layer, the photosensitive layer being a charge generating-transporting layer including a charge generating material (CGM), a hole transporting material (HTM), and a diphenoquinone-based compound including an oxadiazolene group of Formula 1 below as an electron transporting material (ETM), dispersed or dissolved within a binder resin: 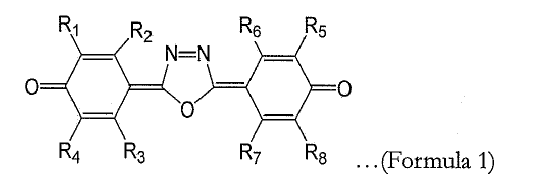 wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

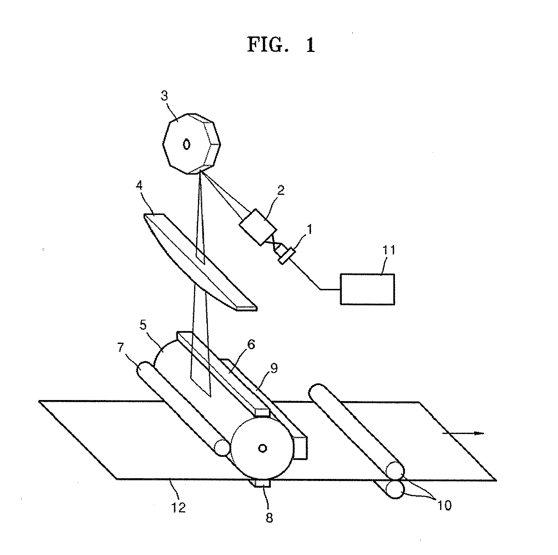

FIG. 1 is a schematic view illustrating an electrophotographic imaging apparatus according to an embodiment of the present invention.

In the first aspect of the present invention, the electrophotographic photoreceptor is a laminated type electrophotographic photoreceptor including a diphenoquinone-based compound having an oxadiazolene group of Formula 1 below as an electron transporting material in a charge generating layer.

In an embodiment, the laminated type electrophotographic photoreceptor according to the present invention has a structure in which a charge generating layer and a charge transporting layer are sequentially formed on an electrically conductive substrate, wherein the charge generating layer and the charge transporting layer together constitute a photosensitive layer. However, the formation sequence of the charge transporting layer and the charge generating layer can be reversed.

The electrically conductive substrate may be in a form of a drum, pipe, belt, plate or the like which may include any conductive material, for example, a metal, or an electrically conductive polymer, or the like. The metal may be aluminium, vanadium, nickel, copper, zinc, palladium, indium, tin, platinum, stainless steel, chrome, or the like. The electrically conductive polymer may be a polyester resin, polycarbonate resin, a polyamide resin, a polyimide resin, mixtures thereof, or a copolymer of monomers used in preparing the resins described above in which an electrically conductive material such as a conductive carbon, tin oxide, indium oxide, or the like is dispersed. An organic polymer sheet on which a metal is deposited or a metal sheet is laminated may be used as the electrically conductive substrate.

An undercoat layer may be further formed between the electrically conductive substrate and the photosensitive layer in order to prevent charge injection to the photosensitive layer from the electrically conductive substrate and/or improve adhesion therebetween.

The undercoat layer may be formed by dispersing a conductive powder such as carbon black, graphite, metal powder, or a metal oxide powder such as indium oxide, tin oxide, indium tin oxide, or titanium oxide in a binder resin such as polyamide, polyvinylalcohol, casein, ethylcellulose, gelatin, a phenol resin, or the like. The undercoat layer in this form may have a thickness of about 5 µm to about 50 µm. The undercoat layer may be also formed of an inorganic layer, for example, anodic aluminium oxide, aluminium oxide, and aluminium hydroxide. The inorganic layer, such as the anodic aluminium oxide, has a thickness in the range of approximately 0.05 µm to approximately 5 µm. These two types of undercoat layers may be formed together.

The charge generating layer and the charge transporting layer are formed on the electrically conductive substrate or the undercoat layer of the laminated type electrophotographic photoreceptor in an embodiment of the present invention.

The charge generating layer is formed of a charge generating material (CGM), and a diphenoquinone-based compound including an oxadiazolene group of Formula 1 as an electron transporting material (ETM) dispersed and/or dissolved within a binder resin.

Specific examples of the CGM that can be used include organic materials such as a phthalocyanine-based compound, an azo-based compound, a bisazo-based compound, a triazo-based compound, a quinone-based compound, a perylene-based compound, an indigo-based compound, a bisbenzoimidazole-based pigment, an anthraquinone-based compound, a quinacridone-based compound, an azulenium-based compound, a squarylium-based compound, a pyrilium-based compound, a triarylmethane-based compound, a cyanine-based compound, a perynone-based compound, a polycycloquinone-based compound, a pyrrolopyrrole-based compound and a naphthalocyanine-based compound; and inorganic materials such as amorphous silicon, amorphous selenium, rhombohedral selenium, tellurium, selenium-tellurium alloy, cadmium sulfide, antimony sulfide, and zinc sulfide. The CGM that can be used in the photosensitive layer is not limited thereto, and the CGMs above may be used individually, or in a mixture of two or more CGMs.

The CGM of the present invention may be a phthalocyanine-based compound. The phthalocyanine-based compound may also be represented by Formula 2 or 3 below. The phthalocyanine-based compound may be a metal-free phthalocyanine-based compound represented by Formula 2, a metallic phthalocyanine-based compound represented by Formula 3 or a mixture thereof. 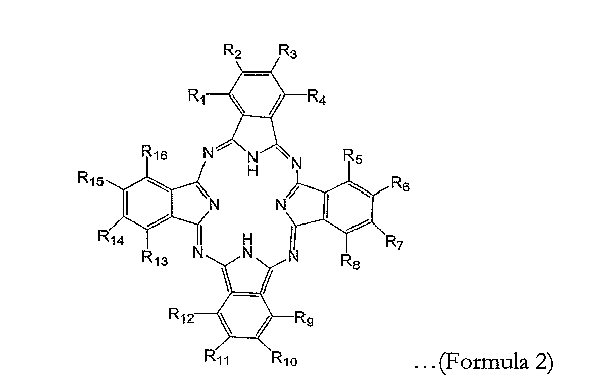 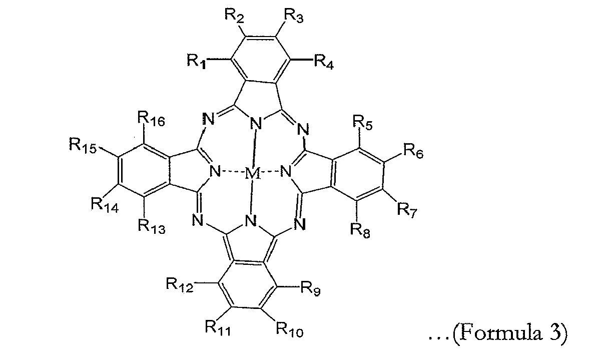 wherein R1 to R16 are each independently one selected from a hydrogen atom, a halogen atom, a nitro group, a C₁-C₂₀ substituted or unsubstituted alkyl group, a C₁-C₇ substituted or unsubstituted alkyl group, and a C₁-C₂₀ substituted or unsubstituted alkoxy group, a C₁-C₇ substituted or unsubstituted alkoxy group, and M is Cu, Fe, Mg, Sn, Pb, Zn, Co, Ni, Mo, or halogenated aluminum; or Ti, V, Zr, Ge, Ga, Sn, Si or In with an oxygen atom, halogen atom, or hydroxy group bonded thereto. The alkyl groups and the alkoxy groups may be substituted with an appropriate substituent group. Specific examples of the phthalocyanine-based compound include metal-free phthalocyanine, oxotitanyl phthalocyanine, oxovanadyl phthalocyanine, copper phthalocyanine, aluminum chloride phthalocyanine, gallium chloride phthalocyanine, indium chloride phthalocyanine, germanium dichloride phthalocyanine, aluminum hydroxide phthalocyanine, gallium hydroxide phthalocyanine, indium hydroxide phthalocyanine, and germanium dihydroxide phthalocyanine or any combinations thereof. In particular, examples of the phthalocyanine-based pigment may include a titanyloxy phthalocyanine pigment such as D-type or Y-type titanyloxy phthalocyanine having the strongest diffraction peak at a Bragg angle of about 27.1°(26±0.2°), a β-type titanyloxy phthalocyanine having the strongest diffraction peak at a Bragg angle of about 26.1°(26±0.2°), an α-type titanyloxy phthalocyanine having the strongest diffraction peak at a Bragg angle of about 7.5°(26±0.2°), or the like, in a powder X-ray diffraction peak; or a metal-free phthalocyanine pigment such as X-type metal-free phthalocyanine or τ-type metal-free phthalocyanine having the strongest diffraction peak at Bragg angles of about 7.5°and about 9.2°(26±0.2°) in a powder X-ray diffraction peak. These phthalocyanine-based pigments can be effectively used in the present embodiment because the phthalocyanine-based pigments have the best sensitivity to light with a wavelength of 780 nm - 800 nm and the sensitivities can be selected depending on crystal structures.

The phthalocyanine compound of Formula 2 or 3 can be synthesized using well-known methods such as those disclosed in F.H. Moser, A.L.Thomas, Phthalocyanine Compounds, 1963; PB85172 FIAT, Final Report, 1313, Feb. 1, 1948, and Japanese Patent Publication Nos. 1-142658 and 1-221461.

The charge generating layer of the laminated type electrophotographic photoreceptor may further include, besides the CGM, a diphenoquinone-based compound including an oxadiazolene group represented by Formula 1 below as an ETM.

The diphenoquinone-based compound including an oxadiazolene group represented by Formula 1 below has good electron transporting characteristics. Accordingly, the laminated type electrophotographic photoreceptor in accordance with the present invention has excellent electrical properties, such as high charge potential and the stability of the charged potential, by further including the diphenoquinone-based compound including the oxadiazolene group of Formula 1 as an electron transporting material, on a conventional charge generating layer including a CGM and a binder resin. This is believed to be because, by further adding the ETM in the charge generating layer in addition to the CGM, electrons generated from the CGM can be transported to the electrically conductive substrate quickly and efficiently, and electron injection from the charge generating layer to the electrically conductive substrate is more convenient. Therefore, a high-quality image can be stably obtained using the electrophotographic photoreceptor according to the present invention. 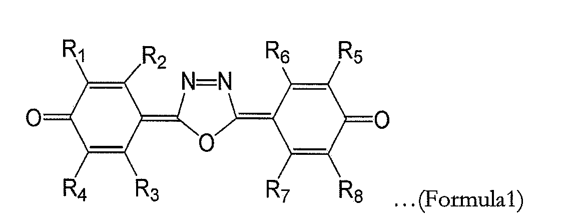 wherein R₁, R₂, R₃, R₄, R₅, R₆, R₇ and R₈ may each independently be one selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted arakyl group, a halogen atom, a nitro group, a cyano group, and a sulfonic acid group.

Halogen atoms include fluorine, chlorine, bromine, iodine, and the like.

The alkyl group refers to a C₁-C₂₀ straight-chained or branched alkyl group, and a C₁-C₁₂ straight-chained or branched alkyl group. Examples of such alkyl group may be methyl, ethyl, n-propyl, isopropyl, n-butyl, isobutyl, sec-butyl, tert-butyl, pentyl, hexyl, 1,2-dimethylpropyl, and 2-ethylhexyl. The alkoxy group may be substituted with a halogen atom such as fluorine, chlorine, bromine, or iodine.

The alkoxy group refers to a C₁-C₂₀ straight-chained or branched alkoxy group, and a C₁-C₁₂ straight-chained or branched alkoxy group. Examples of such alkoxy group may be methoxy, ethoxy, propoxy, and butoxy. The alkyl group may be substituted with a halogen atom such as fluorine, chlorine, bromine, or iodine.

The aryl group refers to a C₆-C₃₀ aromatic ring. Examples of the aryl group include phenyl, tolyl, xylyl, biphenyl, o-terphenyl, naphthyl, anthracenyl, and phenathryl. The aryl group may be substituted with an alkyl group, alkoxy group, nitro group, hydroxyl group, sulfonic acid group, or a halogen atom.

The aralkyl group refers to a C₇-C₃₀ straight-chained or branched aralkyl group, and a C₇-C₁₅ straight-chained or branched aralkyl group. Specific examples of the aralkyl group may include benzyl group, methylbenzyl group, phenylethyl group, naphthylmethyl group, and naphthylethyl group. The aralkyl group may be substituted with an alkyl group, alkoxy group, nitro group, hydroxyl group, sulfonic acid group, or a halogen atom such as fluorine, chlorine, bromine, or iodine.

Specific examples of the diphenoquinone-based compound including the oxadiazolene group represented by Formula 1 of the present invention are the compounds represented by the structures below:

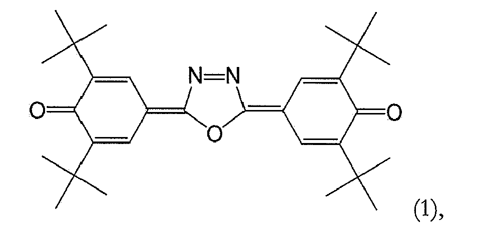

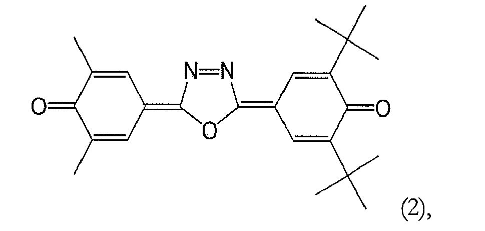

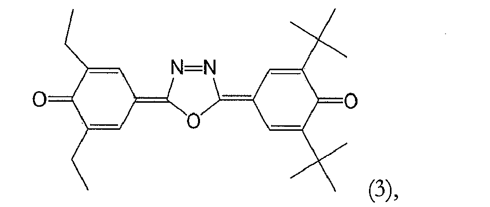

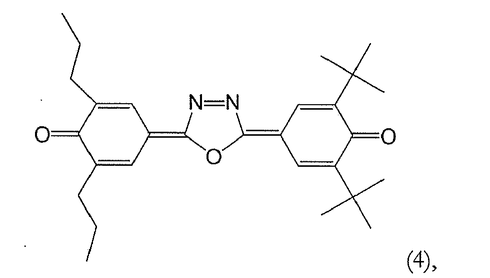

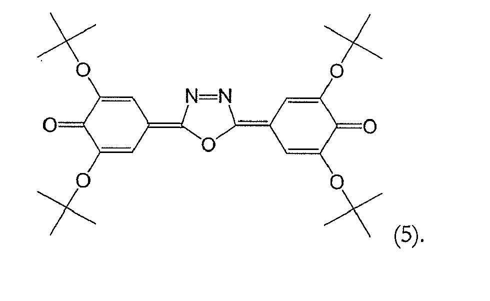

Next, a method of synthesizing the diphenoquinone-based compound including the oxadiazolene group of the present invention will be described.

The diphenoquinone-based compound including the oxadiazolene group can be synthesized using a well-known method disclosed in Japanese Patent Laid-Open Publication Nos. 1994-107648 and 2000-273091, U.S. Patent Laid-Open Publication Nos. US2003/0153758 A1 and US2003/0130326 A1, U.S. Patent Nos. 5,670,526, 4,405,793, and 4,141,729, and Korean Patent Laid-Open Publication No. 2002-0075356.

Reaction Equation 1 below describes a synthesis scheme used to synthesize the diphenoquinone-based compound including the oxadiazolene group according to the present invention.

Referring to Reaction Equation 1, first, a 4-hydroxybenzoic acid derivative and hydrazine are reacted to couple the 4-hydroxybenzoic acid derivative. This reaction is completed by maintaining a reflux state for 1 to 4 hours, such as 2 to 3 hours in a 96% sulfuric acid solvent. Stoichiometrically, a total of 2 moles of the 4-hydroxybenzoic acid derivative react with 1 mole of hydrazine, but in order to increase the yield, a total of 2 or more moles and a total of 2 to 2.4 moles of the hydroxyl benzoic acid derivative may be used. The product of the first coupling reaction is refluxed in the presence of a 2-4 times excess of polyphosphoric acid solvent for 1 to 4 hours, such as for 1 to 3 hours, and is dehydrated and condensed to close the ring of the coupled linking group, thereby producing an oxadiazolene group. Finally, the product of the second reaction may be refluxed in the presence of approximately 2 to 10 times excess of chlorinated hydrocarbon such as chloroform or dichloromethane, and manganese dioxide as an oxidizing agent, for 2 to 6 hours, such as for 3 to 5 hours, to oxidize the hydroxyl groups to ketone groups, thereby obtaining the diphenoquinone-based compound including the oxadiazolene group used as the ETM in the present invention.

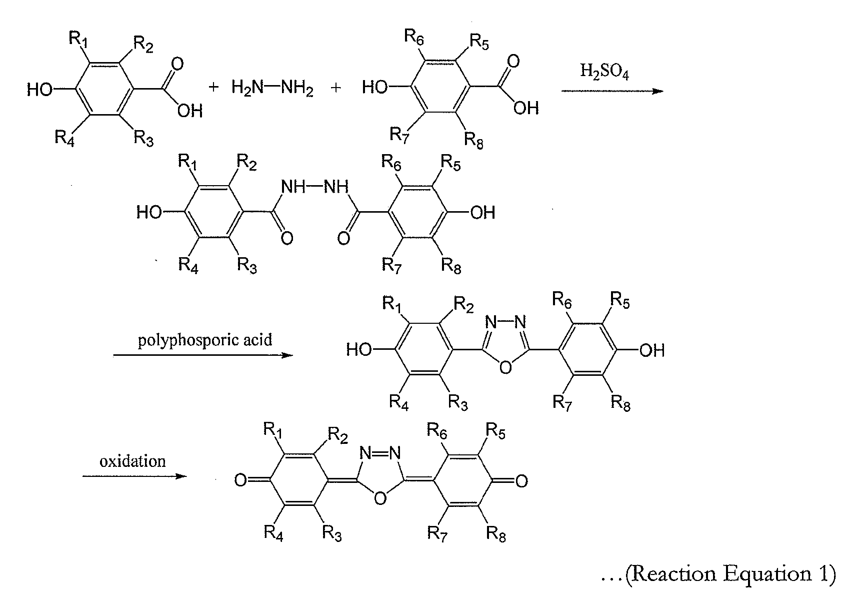

The content of the ETM of Formula 1 in the charge generating layer of the laminated type electrophotographic photoreceptor according to the present invention may be 0.5-10 parts by weight, such as 2-8 parts by weight, such as 3-7 parts by weight based on 100 parts by weight of the CGM. If the content of the ETM is less than 0.5 parts by weight based on 100 parts by weight of the CGM, the residual potential may not be reduced enough due to insufficient amount of the ETM. If the content of the ETM exceeds 10 parts by weight based on 100 parts by weight of the CGM, efficient charge generation may not occur due to insufficient amount of the CGM.

The CGM and the ETM of the charge generating layer are dispersed and/or dissolved within the binder resin. Examples of the usable binder resins are polyvinyl butyral, polyvinyl acetal, polyester, polyamide, polyvinyl alcohol, polyvinyl acetate, polyvinyl chloride, polyurethane, polycarbonate, polymethacryl amide, polyvinyliden chloride, polystyrene, styrene-butadiene copolymer, styrene- methyl methacrylate copolymer, vinylidene chloxide-acrylonitril copolymer, vinylchloride-vinyl acetate copolymer, vinylchloride-vinyl acetate-maleic anhydride copolymer, ethylene-acrylic acid copolymer, ethylene-vinyl acetate copolymer, methyl cellulose, ethyl cellulose, nitrocellulose, carboxymethyl cellulose, polysilicone, silicon-alkyd resin, phenol-formaldehyde resin, cresol-formaldehyde resin, phenoxy resin, styrene-alkyd resin, poly-N-vinycarbazole resin, polyvinylformal, polyhydroxystyrene, polynobonyl, polycycloolefin, polyvinylpyrrolidone, poly(2-ethyl-oxazoline), polysulfone, melamine resin, urea resin, amino resin, isocyanate resin, epoxy resin and the like. These binder resins may be used alone or in a combination of two or more of them.

The content of the binder resin may be 50 to 150 parts by weight, for example, such as 60 to 100 parts by weight based on 100 parts by weight of the CGM. If the content of the binder resin is less than 50 parts by weight based on 100 parts by weight of the CGM, the CGM is insufficiently dispersed to decrease the stability of the dispersion solution, obtaining a uniform charge generating layer when the binder resin is coated on an electrically conductive substrate is difficult, and the adhesive force with the electrically conductive substrate may be reduced. If the content of the binder resin exceeds 150 parts by weight based on 100 parts by weight of the CGM, maintaining a charged potential is difficult, and a desirable image cannot be obtained due to an insufficient sensitivity caused by the excess binder resin.

A type of solvent used in manufacturing coating slurry to form the charge generating layer may be changed according to a type of binder resin used. Accordingly, a solvent which does not affect an adjacent layer when the charge generating layer is coated on the electrically conductive substrate, for example, is selected. Particular examples of the solvents include methyl isopropyl ketone, methyl isobutyl ketone, 4-methoxy-4-methyl-2-pentanone, isopropyl acetate, t-butyl acetate, isopropyl alcohol, isobutyl alcohol, acetone, methylethyl ketone, cyclohexanone, 1,2-dichloroethane, 1,1,2-trichloroethane, 1,1,1-trichloroethane, trichloroethylene, tetrachloroethane, dichloromethane, tetrahydrofuran(THF), dioxane, dioxolane, methanol, ethanol, 1-propanol, 1-butanol, 2-butanol, 1-methoxy-2-propanol, ethyl acetate, butyl acetate, dimethyl sulfoxide, methylcellosolve, butyl amine, diethyl amine, ethylene diamine, isopropanol amine, triethanol amine, triethylene diamine, N,N'-dimethyl formamide, 1,2-dimethoxyethane, benzene, toluene, xylene, methylbenzene, ethylbenzene, cyclohexane, anisole, and the like. These solvents may be used alone or in a combination of two or more.

Next, a method of forming the charge generating layer will be described. First, 100 parts by weight of the CGM including a phthalocyanine pigment such as oxotitanyl phthalocyanine, 0.5-10 parts by weight, such as 2-8 parts by weight of the ETM of Formula 1, and 50-150 parts by weight, such as 60-100 parts by weight of the binder resin are mixed together with an appropriate amount of a solvent. The amount of the solvent is determined in such a manner that solids content of the mixture be 1-8 wt%, such as 1-5 wt%. Glass beads, steel beads, zirconia beads, alumina beads, zirconia balls, alumina balls, or steel balls are added to the mixture and the resulting mixture are dispersed using a dispersing apparatus for about 2 to 50 hours. The dispersing apparatus used herein may be, for example, an attritor, a ball-mill, a sand-mill, a Banbury mixer, a roll-mill, a three-roll mill, a nanomiser, a microfluidizer, a stamp mill, a planetary mill, a vibration mill, a kneader, a homonizer, a Dyno-Mill, a micronizer, a paint shaker, a high-speed agitator, an ultimiser, an ultrasonic homogenizer, or the like. The above dispersing apparatuses may be used alone or in combinations of two or more.

The coating slurry to form the charge generating layer is coated on the above-described electrically conductive substrate using a coating method such as a dip coating method, a ring coating method, a roll coating method, a spray coating method, or the like. The coated electrically conductive substrate is dried at 90 to 200°C for 0.1 to 2 hours, thereby forming the charge generating layer.

A thickness of the charge generating layer may be 0.001-10 µm, such as 0.05-2 µm, including 0.1-1 µm. If the thickness of the charge generating layer is less than 0.001 µm, forming the charge generating layer to have a uniform thickness is difficult. When the thickness of the charge generating layer exceeds 10 µm, electrophotographic characteristics tend to deteriorate.

Next, the charge transporting layer including a charge transporting material (CTM) and a binder resin is formed on the charge generating layer. However, the charge generating layer may conversely be formed on the charge transporting layer.

The CTM may either be a hole transporting material (HTM) transporting holes, or an ETM transporting electrons. When the laminated type electrophotographic photoreceptor is negatively charged, the HTM as the CTM is used as a main component. In this case, a small amount of the ETM may be added in order to prevent hole-traps from forming.

Specific examples of the HTM that may be included in the charge transporting layer include nitrogen containing cyclic compounds or condensed polycyclic compounds such as a hydrazone-based compound, a butadiene-based amine compound, a benzidine-based compound including N,N'-bis-(3-methylphenyl)-N,N'-bis(phenyl)benzidine, N,N, N',N'-tetrakis(3-methylphenyl)benzidine, N,N, N',N'-tetrakis(4-methylphenyl)benzidine, N,N'-di(naphthalene-1-yl)-N,N'-di(4-methylphenyl)benzidine, and N,N'-di(naphthalene-2-yl)-N,N'-di(3-methylphenyl)benzidine, a pyrene-based compound, a carbazole-based compound, an arylmethane-based compound, a thiazol-based compound, a styryl-based compound, a pyrazoline-based compound, an arylamine-based compound, an oxazole-based compound, an oxadiazole-based compound, a pyrazolone-based compound, a stilbene-based compound, a polyaryl alkane-based compound, a polyvinylcarbazole-based compound, a N-acrylamide methylcarbazole copolymer, a triphenylmethane copolymer, a styrene copolymer, polyacenaphthene, polyindene, a copolymer of acenaphthylene and styrene, and a formaldehyde-based condensed resin. Also, a high molecular weight compound having substituents of the above compounds in a main chain or a side chain may be used. The HTM may include one or a combination of two or more of the compounds listed above.

In the case where the ETM is included in the charge transporting layer, the ETM that may be used is not particularly limited, and may be a conventional ETM. Specific examples of the ETM include electron-accepting low molecular compounds such as a benzoquinone-based compound, a naphthoquinone-based compound, an anthraquinone-based compound, a malononitrile-based compound, a diphenoquinone-based compound including the diphenoquinone-based compound having dioxazolene group according to the Formula 1, a fluorenone-based compound, a cyanoethylene-based compound, a cyanoquinodimethane-based compound, a xanthone-based compound, a phenanthraquinone-based compound, an anhydrous phthalic acid-based compound, a thiopyran-based compound, a dicyanofluorenone-based compound, a naphthalene tetracarboxylic acid diimide-based compound, a benzoquinoneimine-based compound, a diphenoquinone-based compound, a stilbenequinone-based compound, a diiminoquinone-based compound, a dioxotetracenedione compound and a pyran sulfide-based compound.

Moreover, the ETM may include electron transporting polymers or n-type semiconducting pigments.

If the CTM itself has film-forming characteristics, the charge transporting layer may be formed without a binder resin, but usually low molecular materials do not have any film-forming characteristics. Therefore, the CTM is dissolved or dispersed with a binder resin in a solvent to prepare a coating composition (solution or dispersion) to form a charge transporting layer, and then the solution or the dispersion is coated on the charge generating layer and dried to form the charge transporting layer. Examples of the binder resin used for a formation of the charge transport layer of the electrophotographic photoreceptor according to the present invention include, but are not limited to, an insulation resin which can form a film, such as polyvinyl butyral, polyarylates (condensed polymer of bisphenol A and phthalic acid, and so on), polycarbonate, a polyester resin, a phenoxy resin, polyvinyl acetate, acrylic resin, a polyacrylamide resin, a polyamide, polyvinyl pyridine, a cellulose-based resin, a urethane resin, an epoxy resin, a silicone resin, polystyrene, a polyketone, polyvinyl chloride, vinyl chloride-vinyliacetate copolymer, polyvinyl acetal, polyacrylonitrile, a phenolic resin, a melamine resin, casein, polyvinyl alcohol, and polyvinyl pyrrolidone; and an organic photoconductive polymer, such as poly N-vinyl carbazole, polyvinyl anthracene, polyvinyl pyrene, and so on. However, in an embodiment, a polycarbonate resin is used as a binder resin to form a charge transporting layer. In one particular embodiment, polycarbonate-Z derived from cyclohexylidene bisphenol is used, rather than polycarbonate-A derived from bisphenol A or polycarbonate-C derived from methylbisphenol-A, because polycarbonate-Z has a high abrasion resistance.

A content ratio of the HTM and the binder resin within the charge transporting layer may be 50 to 200 parts by weight of the binder resin based on 100 parts by weight of the HTM. The content ratio, for example, may be 100 to 160 parts by weight of the binder resin based on 100 parts by weight of the HTM. If the binder resin content exceeds 200 parts by weight based on 100 parts by weight of the HTM, the charge transporting ability is insufficient and thus producing an electrophotographic photoreceptor having a reduced sensitivity and a high residual potential. Alternatively, if the binder resin content is less than 50 parts by weight based on 100 parts by weight of the HTM, the relative binder resin content becomes too low such that the mechanical strength may be decreased. The content of the ETM within the charge transporting layer may be 0 to 50 parts by weight, such as 5 to 30 parts by weight based on 100 parts by weight of the HTM.

The solvent used to prepare the coating composition to form the charge transporting layer of the electrophotographic photoreceptor may be varied according to a type of the binder resin, and may be selected in such a way that the charge generating layer formed underneath is not affected. Specifically, the solvent may be, for example, aromatic hydrocarbons such as benzene, xylene, ligroin, monochlorobenzene, and dichlorobenzene; ketones such as acetone, methyl ethyl ketone, and cyclohexanone; alcohols such as methanol, ethanol, and isopropanol; esters such as ethyl acetate and methyl cellosolve; halogenated aliphatic hydrocarbons such as carbon tetrachloride, chloroform, dichloromethane, dichloroethane, and trichloroethylene; ethers such as tetrahydrofuran(THF), dioxane, dioxolan, ethylene glycol, and monomethyl ether; amides such as N,N-dimethyl formamide, N,N-dimethyl acetamide; and sulfoxides such as dimethyl sulfoxide. These solvents may be used alone or in combination of two or more.

Next, a method of forming the charge transporting layer will be described.

First, 100 parts by weight of an HTM, 50-200 parts by weight, such as 100-160 parts by weight of a binder resin, and 0-50 parts by weight, such as 5-30 parts by weight of the ETM are mixed together with an appropriate amount of a solvent. The amount of the solvent is determined in such a manner that the solids content of the mixture be 10-30 wt%, such as 15-25 wt%. The prepared coating composition to form the charge transporting layer is coated on the charge generating layer using, as described above, a dip coating method, a ring coating method, a roll coating method, a spray coating method, or the like. The electrically conductive substrate on which the charge transporting layer is coated is dried at 90 to 200°C for 0.1 to 2 hours, thereby forming the charge transporting layer.

A thickness of the charge transporting layer may be 2 to 100 µm, such as 5 to 50 µm, including 10 to 40 µm. When the thickness of the charge transporting layer is less than 2 µm, the charge transporting layer is too thin, and thus durability is not sufficient and charging characteristics become poor. When the thickness of the charge transporting layer exceeds 100 µm, physical abrasion resistance may increase but a response time and printing image quality tend to be deteriorated. The combined thickness of the charge generating layer and the charge transporting layer may be conventionally selected from the range of 5 to 50 µm.

The charge transporting layer may further include an appropriate amount of a phosphate-based compound, a phosphine oxide-based compound, a silicone oil, or the like in order to enhance the abrasion resistance and provide lubricating characteristics to the surface of the charge transporting layer.

Hereinafter, a single-layer type electrophotographic photoreceptor including a diphenoquinone-based compound including an oxadiazolene group of Formula 1 as an electron transporting material in a single-layer type photosensitive layer according to the second aspect of the present invention will be fully described.

The single-layer type electrophotographic photoreceptor according to this aspect of the present invention is an electrophotographic photoreceptor including an electrically conductive substrate and a photosensitive layer formed on the electrically conductive substrate, wherein the photosensitive layer is a charge generating-transporting layer including a CGM, a HTM, and a diphenoquinone-based compound including an oxadiazolene group of Formula 1 as an ETM, dispersed or dissolved within a binder resin.

The contents of each element in the photosensitive layer of the single-layer type electrophotographic photoreceptor may be in the ranges of, 3-15 parts by weight, such as 5-10 parts by weight of the CGM; 20-80 parts by weight, such as 40-60 parts by weight of the HTM; 0.5-3 parts by weight, such as 1-2 parts by weight of an electron-accepting material; and 100-300 parts by weight, such as 150-250 parts by weight of the binder resin, based on 100 parts by weight of the diphenoquinone-based ETM of Formula 1.

The electron-accepting material is used in order to improve the dark decay characteristics and reduce fatigue during repeated use and the like. Specific examples of such electron-accepting material include anhydrous succinic acid, anhydrous maleic acid, dibromo-anhydrous succinic acid, anhydrous phthalic acid, 3-nitro anhydrous phthalic acid, 4-nitro anhydrous phthalic acid, anhydrous pyromellitic acid, pyromellitic acid, trimellitic acid, anhydrous trimellitic acid, phthalimide, 4-nitrophthalimide, tetracyanoethylene, tetracyanoquinodimethane, chloranyl, bromanyl, o-nitro benzoic acid, p-nitro benzoic acid and the like, which are compounds with high electron affinity.

If the content of the CGM is less than 3 parts by weight based on 100 parts by weight of the diphenoquinone-based ETM of Formula 1, the charge generation may be insufficient that maintaining the charged potential is difficult, and the sensitivity may thus be reduced due to a presence of excess binder resin. If the content of the CGM exceeds 15 parts by weight based on 100 parts by weight of the diphenoquinone-based ETM of Formula 1, the CGM may be insufficiently dispersed that the stability of the composition to form the photosensitive layer may be decreased, and a homogenous photosensitive layer becomes difficult to obtain when coated on the electrically conductive substrate, and the adhesion strength may also be decreased.

If the content of the HTM is less than 20 parts by weight based on 100 parts by weight of the diphenoquinone-based ETM of Formula 1, the hole mobility may be decreased, thereby lowering the sensitivity, and if the content exceeds 80 parts by weight based on 100 parts by weight of the diphenoquinone-based ETM of Formula 1, the electron mobility may be decreased, thereby lowering the sensitivity.

If the content of the electron accepting material is less than 0.5 parts by weight based on 100 parts by weight of the diphenoquinone-based ETM of Formula 1, an increase in the dark decay characteristics of the photoreceptor may not be sufficient, and if the content is greater than 3 parts by weight based on 100 parts by weight of the diphenoquinone-based ETM of Formula 1, the electron accepting material acts as impurities, lowering the dispersing stability of the composition to form the photosensitive layer, suppressing the properties of electron transporting materials, and even decreasing the dark decay characteristics.

If the content of the binder resin is less than 100 parts by weight based on 100 parts by weight of the diphenoquinone-based ETM of Formula 1, the CGM is insufficiently dispersed, and lowers dispersing stability of the composition to form the photosensitive layer, and obtaining a homogenous photosensitive layer when coated on the electrically conductive substrate is difficult, and the adhesion strength may also deteriorate. If the content of the binder resin is greater than 300 parts by weight, if becomes difficult to maintain the charged potential, and the photoreceptor sensitivity may be lowered due to presence of excess binder resin.

Next, a method of preparing the single-layered type electrophotographic photoreceptor will be described.

First, 100 parts by weight of the diphenoquinone-based ETM including the oxadiazolene group of Formula 1, 3-15 parts by weight of a CGM, 20-80 parts by weight of an HTM, 0.5-3 parts by weight of an electron accepting material, and 100-300 parts by weight of a binder resin are mixed together with an appropriate amount of a solvent. The amount of the solvent is determined in such a manner that the solids content of the mixture be 10-30 wt%, such as 15-25 wt%. Specific examples of the solvent used in preparing the coating slurry to form a single-layered type electrophotographic photoreceptor may be appropriately selected from the previously mentioned solvents. Glass beads, steel beads, zirconia beads, alumina beads, zirconia balls, alumina balls, or steel balls are added to the mixture and the resulting mixture are dispersed using a dispersing apparatus for about 2 to 50 hours. Here, the mixture may be dispersed using grinding or milling. The dispersing apparatus used herein may be, for example, an attritor, a ball-mill, a sand-mill, a Banbury mixer, a roll-mill, three-roll mill, nanomiser, microfluidizer, a stamp mill, a planetary mill, a vibration mill, a kneader, a homonizer, a Dyno-Mill, a micronizer, a paint shaker, a high-speed agitator, an ultimiser, an ultrasonic homogenizer, or the like. The above dispersing apparatuses may be used alone or in combination of two or more.

The coating slurry to form the single-layered type photosensitive layer is coated on the above-described electrically conductive substrate using a coating method such as a dip coating method, a ring coating method, a roll coating method, a spray coating method, or the like. The electrically conductive substrate coated as such is dried at 90 to 200°C for 0.1 to 2 hours, thereby forming the single-layered type photosensitive layer.

The thickness of the single-layered type photosensitive layer may generally be about 5 to 50 µm, such as 10 to 40 µm, including 15 to 30 µm, and including 15 to 20 µm. If the thickness of the single-layered type photosensitive layer is less than 5 µm, the sensitivity and the mechanical strength may be insufficient, and if the thickness exceeds 50 µm, the total thickness of the single-layered type photosensitive layer becomes too great, thereby deteriorating the electrical properties.

The photosensitive layer according to the present embodiment may further include, along with the binder resin, additives such as a plasticizer, a surface modifier, a dispersion stabilizer, and an antioxidant, regardless of whether the electrophotographic photoreceptor is a laminated type or a single-layered type photoreceptor.

The plasticizer may include, for example, biphenyl, biphenyl chloride, terphenyl, dibutyl phthalate, diethylene glycol phthalate, dioctyl phthalate, triphenyl phosphoric acid, methyl naphthalene, benzophenone, a chlorinated paraffin, polypropylene, polystyrene, and various fluorinated hydrocarbons, but is not limited thereto. The surface modifier that may be used in the present invention may include, for example, a silicone oil, and a fluorine resin, but is not limited thereto. The antioxidant is included in order to improve resistance to environment and stability against harmful light and heat. Specific examples of the antioxidant used in the present embodiment include a chormanol derivative such as tocopherol, or an etherified or esterified compounds thereof, a polyaryl alkane compound, a hydroquinone derivative and a mono- or dietherified compound thereof, a benzophenone derivative, a benzotriazole derivative, a phenylene diamine derivative, a phosphonic acid ester, a hypophosphoric acid ester, a phenolic compound, a sterically-hindered phenolic compound, a straight-chain amine compound, a cyclic amine compound, and a sterically-hindered amine compound, but is not limited thereto.

In the single-layered type electrophotographic photoreceptor according to the present invention, an undercoat layer may be further formed between the electrically conductive substrate and the photosensitive layer in order to prevent charge injection to the photosensitive layer from the electrically conductive substrate and/or improve adhesion therebetween.

The undercoat layer may be formed by dispersing a conductive powder such as carbon black, graphite, metal powder, or a metal oxide powder such as indium oxide, tin oxide, indium tin oxide, or titanium oxide in a binder resin such as polyamide, polyvinylalcohol, casein, ethylcellulose, gelatin, a phenol resin, or the like. The undercoat layer in this form, for example, may have a thickness of about 5 µm to about 50 µm. The undercoat layer may be also formed of an inorganic layer, for example, anodic aluminium oxide, aluminium oxide, and aluminium hydroxide. The inorganic layer, such as the anodic aluminium oxide, may have a thickness in a range of approximately 0.05 µm to approximately 5 µm. These two types of undercoat layers may be formed together.

The electrophotographic photoreceptor of the present embodiment may further include, if necessary, a surface protecting layer on the photosensitive layer.

Hereinafter, an electrophotographic imaging apparatus employing an electrophotographic photoreceptor according to the present embodiment will be described.

The electrophotographic photoreceptor according to the present embodiment may be incorporated into electrophotographic imaging apparatuses such as laser printers, copying machines, facsimile machines, LED printers, and the like.

The electrophotographic imaging apparatus according to the present embodiment includes the single-layer type or the laminated type electrophotographic photoreceptor described above.

FIG. 1 is a schematic view illustrating the electrophotographic imaging apparatus according to an embodiment of the present invention.

Referring to FIG. 1, the electrophotographic imaging apparatus according to the current embodiment of the present invention includes a semiconductor laser 1. Laser light that is signal-modulated by a control circuit 11 according to image information, is collimated by an optical correction system 2 after being radiated and performs scanning while being reflected by a polygonal rotatory mirror 3. The laser light is focused on a surface of an electrophotographic photoreceptor 5 by a f-θ lens 4 and exposes the surface according to the image information. Since the electrophotographic photoreceptor may be already charged by a charging apparatus 6, an electrostatic latent image is formed by the exposure, and then becomes visible by a developing apparatus 7. The visible image is transferred to an image receptor 12, such as paper, by a transferring apparatus 8, and is fixed in a fixing apparatus 10 and provided as a print result. The electrophotographic photoreceptor can be used repeatedly by removing coloring agent that remains on the surface thereof by a cleaning apparatus 9. The electrophotographic photoreceptor here is illustrated in the form of a drum, however, as described above, the present invention is not limited thereto, and may also be in the form of a sheet, a belt, or the like. The electrophotographic photoreceptor 5 according to the present embodiment may be disposed in the electrophotographic imaging apparatus or may also be detached from the electrophotographic imaging apparatus.

In the following detailed description, only certain exemplary embodiments of the present invention have been shown and described, simply by way of illustration. As those skilled in the art would realize, the described embodiments may be modified in various different ways without departing from the scope of the present invention.

### Synthesis Example 1

The present example describes a synthesis process of a diphenoquinone-based compound 1 including the oxadiazolene group used as electron generating material (EGM) in an example of the present inventive concept, with reference to Reaction Equation 2 below.

First, 2 g (0.008 mol) of 3,5-di-tert-butyl-4-hydroxy benzoic acid (Aldrich Co.) and 0.112 g (0.0035 mol) of hydrazine (Aldrich Co., anhydrous, 98%) were added to 15 ml of 96% sulfuric acid, and were refluxed for approximately 2.5 hours to couple 3,5-di-tert-butyl-4-hydroxy benzoic acids. The coupled product was poured into a beaker containing 70 ml of methanol to precipitate, and the beaker was left in a freezer at a temperature of -10°C for about 24 hours. The crystalline product produced was filtered and dried in a vacuum oven to obtain 1.65 g of a coupled product. 1.65 g of the coupled reaction product was then refluxed in 15 ml of polyphosphoric acid (Aldrich Co.) for about 2.5 hours and dehydrated and condensed to close the ring of the coupled linkage group. Thus, an oxadiazolene group was produced. The closed-ring product was poured into a beaker containing 50 ml of ethanol to form a precipitate. Approximately 50 ml of methanol was added to the beaker, and the beaker was left in a freezer at a temperature of -10°C for about 24 hours. The crystalline product produced was filtered and dried in a vacuum oven to obtain 1.7 g of the closed-ring product.

Finally, 1.53 g of the closed-ring product was refluxed under the presence of 3.4 g of manganese dioxide (Aldrich Co.) in 50 ml of chloroform for about 4 hours, oxidizing the hydroxyl groups into ketone groups. The reaction product was filtered using a silica gel filter to remove the manganese dioxide. The filtrate was poured into a beaker containing about 70 ml of ethanol to form a precipitate. The beaker was left in a freezer at a temperature of -10°C for about 24 hours. The produced crystalline product was filtered and dried under a vacuum oven to obtain 1.33 g (yield 70%) of diphenoquinone-based compound (1) including the oxadiazolene group.

A proton nuclear magnetic resonance (¹H NMR) chart of the product identified the following peaks:
¹H NMR (CDCl3, δppm): 1.15-1.17(s, 3H, 12CH₃), 6.83-6.84(s, 1H, 4 on aromatic ring)

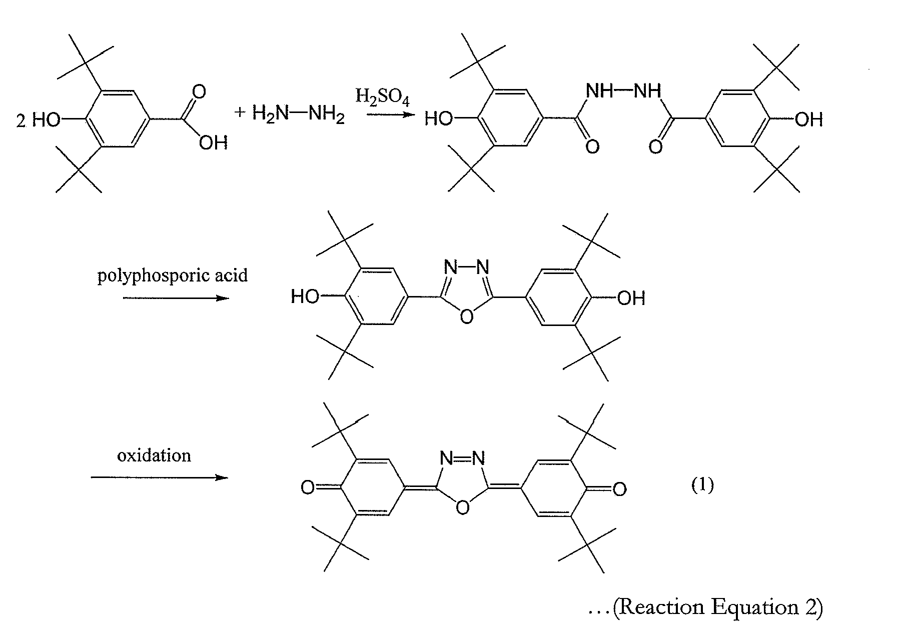

### Example 1

3 parts by weight of X-type metal-free phthalocyanine of the compound 10 below as a charge generating material (CGM), 29.7 parts by weight of the diphenoquinone-based compound including the oxadiazolene group obtained in Synthesis Example 1 as an electron transporting material (ETM), 14.9 parts by weight of the arylamine-based hole transporting material (HTM) of the compound 12 below, and 52.4 parts by weight of polycarbonate resin (Mitsubishi Gas Chemical, PCZ200) of the compound 22 below as a binder resin were added to a mixed solvent of 280 parts by weight of methylene chloride and 120 parts by weight of 1,1,2-trichloroethane. The mixture was sand-milled for 2 hours and was dispersed by ultrasonication. The coating slurry to form a single-layered type photosensitive layer obtained as such was coated evenly on an aluminum drum with an anodized aluminium (alumite) surface layer with a diameter of 24 rom Φ, a length of 236 mm and a thickness of 1 mm, and then was dried at 110°C for 1 hour to form a photosensitive layer with a thickness of 15 to 16 µm, thereby completing the preparation of a single-layered type electrophotographic photoreceptor drum.

### Example 2

A single-layered type electrophotographic photoreceptor drum was prepared according to the method described in Example 1, except that the amount of the diphenoquinone-based compound 1 including an oxadiazolene group used was changed to 29.2 parts by weight, and 0.5 parts by weight of the electron accepting material of the compound 20 below were further used.

### Comparative Example 1

A single-layered type electrophotographic photoreceptor drum was manufactured according to the method described in Example 1, except that 29.7 parts by weight of a conventional diphenoquinone-based compound not including the oxadiazolene group of the compound 14 was used instead of the diphenoquinone-based compound 1 including the oxadiazolene group as the electron transporting material.

### Comparative Example 2

A single-layered type electrophotographic photoreceptor drum was manufactured according to the method described in Example 1, except that 29.7 parts by weight of compound 16 below, a dicyanofluorene-based compound, was used instead of the diphenoquinone-based compound 1 including the oxadiazolene group as the electron transporting material.

### Comparative Example 3

A single-layered type electrophotographic photoreceptor drum was manufactured according to the method described in Example 2, except that 29.2 parts by weight of the conventional diphenoquinone-based compound not including the oxadiazolene group of the compound 14 was used instead of the diphenoquinone-based compound 1 including the oxadiazolene group as the electron transporting material.

### Comparative Example 4

A single-layered type electrophotographic photoreceptor drum was manufactured according to the method described in Example 2, except that 29.2 parts by weight of dicyanofluorene-based compound of the compound 16 was used instead of the diphenoquinone-based compound 1 including the oxadiazolene group as the electron transporting material.

### Example 3

A mixture of 7.4 parts by weight of the X-type metal-free phthalocyanine of the compound 10 below as a CGM, 0.5 parts by weight of the diphenoquinone-based compound including the oxadiazolene group as an ETM, 3.6 parts by weight of polyvinylbutylal resin (BM2, Sekisui Chemicals), and 100 parts by weight of tetrahydrofuran (THF) were dispersed with glass beads of diameter 1 to 1.5 mm using a paint shaker for 30 minutes, and the mixture was then ball-milled for 30 minutes. This process was repeated four times. 250 parts by weight of THF was added to the resulting product to obtain a coating slurry to form a charge generating layer.

The coating slurry was coated evenly on an aluminium drum with an anodized aluminium surface layer with a diameter of 24 mmΦ, a length of 236 mm, and a thickness of 1 mm, and was dried at 150 °C for 1 hour to obtain a charge generating layer having a thickness 0.1-0.5 µm.

12.4 parts by weight of an arylamine-based HTM of the compound 12 below, and 15.7 parts by weight of polycarbonate resin (Mitsubishi Gas Chemical, PCZ200) of the compound 22 below were dissolved in a mixed solvent of 92.7 parts by weight of THF and 30 parts by weight of xylene to prepare a coating solution to form a charge transporting layer.

The coating solution was applied on the charge generating layer and dried at 150°C for 1 hour to obtain a charge transporting layer having a thickness 20 µm. Thus, the preparation of a laminated type photoreceptor drum was completed.

### Comparative Example 5

laminated type photoreceptor drum was manufactured according to the method described in Example 3, except that the electron transporting material was not added when forming the charge generating layer.

### Comparative Example 6

A laminated type photoreceptor drum was manufactured according to the method described in Example 3, except that 0.5 parts by weight of a conventional diphenoquinone-based compound 14 not including the oxadiazolene group was used instead of the diphenoquinone-based compound 1 including the oxadiazolene group as the electron transporting material, when forming the charge generating layer.

### Comparative Example 7

A laminated type photoreceptor drum was manufactured according to the method described in Example 3, except that 0.5 parts by weight of dicyanofluorene-based compound 16 was used instead of the diphenoquinone-based compound 1 including the oxadiazolene group as the electron transporting material, when forming the charge generating layer.

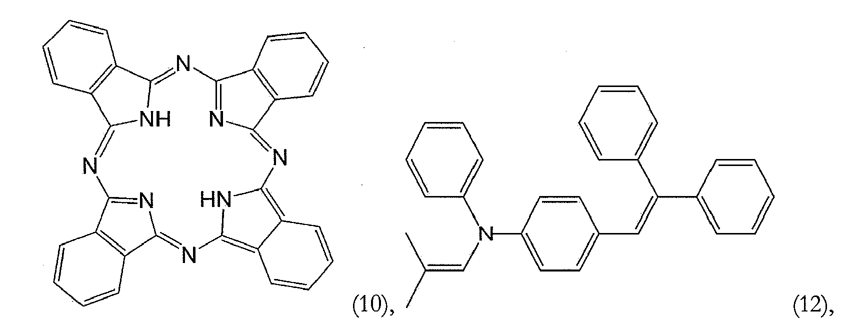

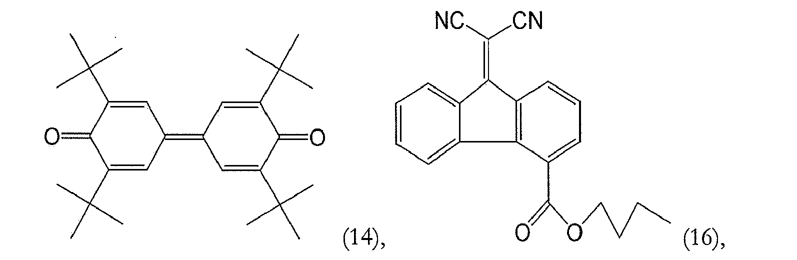

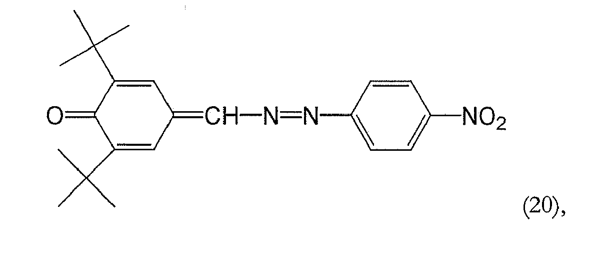

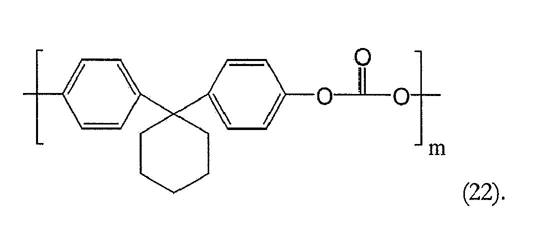

### Evaluation of Electrical Properties

The electrical properties of the electrophotographic photoreceptor drums prepared in Examples 1 to 3 and Comparative Examples 1 to 7 were measured using an electrical property evaluating apparatus (Gentec Co., Model Name: Cynthia92KSS), at a temperature of 23°C and relative humidity of 50%.

The measurement conditions were as follows:
Rotational speed of photoreceptors: 50 rpm
Applied voltage when charging :
For laminated type photoreceptors, DC (-) 800V
For single-layered type photoreceptors, DC (+) 800V
Wavelength of light used for exposure : 780 nm monochromatic light

In the above measurement conditions, the initial charge potential (V₀ initial) of the photoreceptor drums, initial exposure potential (V_{d} initial), charge potential after performing 6,000 cycles of charging and exposure (Vₒ₋6k), and exposure potential (V_{d-}6k) after performing 6,000 cycles of charging and exposure were obtained.

Table 1 illustrates the electrical property evaluation results.

**Table 1**

| | Electron Transporting Material (ETM) | Electron Accepting Material (EAM) | Vo initial | Vd initial | Vo_6k | Vd_6k |
|---|---|---|---|---|---|---|
| Example 1 | Compound 1 29.7 parts by weight | - | 690 | 96 | 660 | 100 |
| Example 2 | Compound 2 29.2 parts by weight | Compound 20 0.5 parts by weight | 690 | 110 | 675 | 113 |
| Comparative Example 1 | Compound 14 29.7 parts by weight | - | 600 | 92 | 450 | 99 |
| Comparative Example 2 | Compound 16 29.7 parts by weight | - | 620 | 100 | 515 | 115 |
| Comparative Example 3 | Compound 14 29.2 parts by weight | Compound 20 0.5 parts by weight | 615 | 106 | 540 | 118 |
| Comparative Example 4 | Compound 16 29.2 parts by weight | Compound 20 0.5 parts by weight | 650 | 115 | 525 | 121 |
| Example 3 | Compound 1 0.5 parts by weight | - | 690 | 55 | 680 | 71 |
| Comparative Example 5 | - | - | 690 | 76 | 650 | 92 |
| Comparative Example 6 | Compound 14 0.5 parts by weight | - | 690 | 62 | 673 | 90 |

Referring to Table 1, in the case of Example 1 including 29.7 parts by weight of the diphenoquinone-based compound including the dioxadiazolene group as the electron transporting material, the initial charge potential was high, and even after 6,000 cycles, the charge potential only decreased by 30 V and from this the charge potential stability is good. In the case of Example 2 which includes 29.2 parts by weight of the diphenoquinone-based compound 1 including the oxadiazolene group as the electron transporting material and 0.5 parts by weight of the electron accepting material, the initial charge potential was high, and it was found that even after 6,000 cycles, the charge potential was maintained better than in Example 1. Thus, the diphenoquinone-based compound including the oxadiazolene group represented by Formula 1 used as the electron transporting material has excellent electron transporting characteristics.

In the case of Comparative Examples 1 to 4 using the conventional diphenoquinone-based compound 14 not including the oxadiazolene group as the electron transporting material or the dicyanofluorene-based compound 16, all of the charge potentials were lower than the respective charge potentials of Examples 1 and 2 regardless of whether the electron accepting material was used, and also the charge potential stability was found to be very poor.

Such trends were also confirmed in Example 3 and Comparative Example 5 to 7, with regards to the laminated type electrophotographic photoreceptor drums.

A diphenoquinone-based compound including an oxadiazolene group of Formula 1 used in the present embodiment has excellent electron transporting characteristics. Therefore, the laminated type electrophotographic photoreceptor according to the present embodiment has excellent electrical properties such as high charge potential and charge potential stability by further including the diphenoquinone-based compound including the oxadiazolene group of Formula 1 as an electron transporting material, in the charge generating layer including a CGM and a binder resin. This is because, by further adding the ETM on the charge generating layer in addition to the CGM, electrons generated from the CGM can be transported to an electrically conductive substrate quickly and efficiently, and electron injection from the charge generating layer to the electrically conductive substrate is more convenient. Therefore, a high-quality image can be stably obtained using the electrophotographic photoreceptor according to the present invention.

Whilst the present invention has been described in connection with certain exemplary embodiments thereof, it is to be understood that the invention is not limited to the disclosed embodiments, but includes various modifications and equivalent arrangements included within the scope of the appended claims.

## Claims

1. An electrophotographic photoreceptor, comprising:
an electrically conductive substrate;
a charge generating layer formed on the electrically conductive substrate, the charge generating layer including a charge generating material (CGM) and an electron transporting material (ETM) having a diphenoquinone-based compound including an oxadiazolene group represented by Formula 1 below, dispersed or dissolved within a binder resin; and
a charge transporting layer formed on the charge generating layer, the charge transporting layer including a charge transporting material (CTM) dispersed or dissolved within a binder resin: 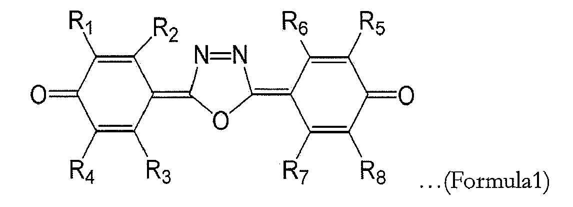
wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

2. The electrophotographic photoreceptor of claim 1, wherein the CGM is selected from the group consisting of a metal-free phthalocyanine-based compound represented by Formula 2 below, a metallic phthalocyanine-based compound represented by Formula 3 below, and mixtures thereof: 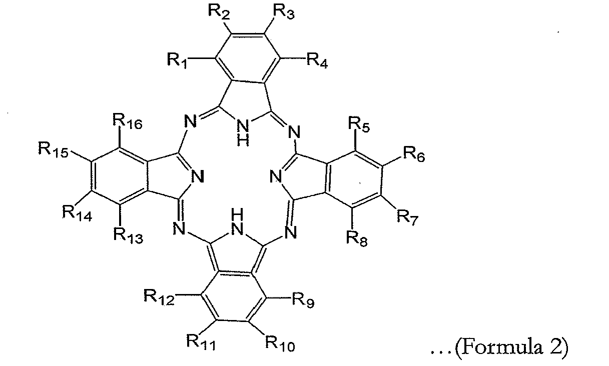 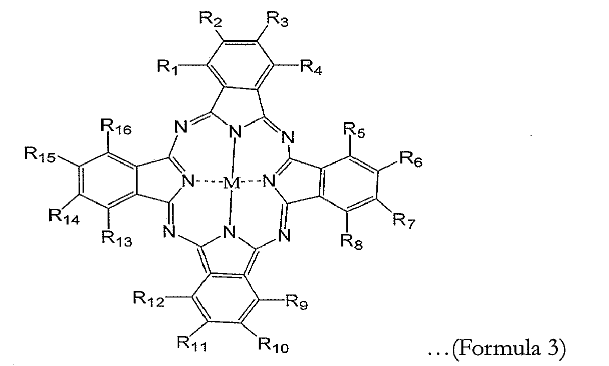 wherein R₁ to R₁₆ are each independently selected from a hydrogen atom, a halogen atom, a nitro group, a C₁-C₂₀ substituted or unsubstituted alkyl group and a C₁-C₂₀ substituted or unsubstituted alkoxy group, and M is Cu, Fe, Mg, Sn, Pb, Zn, Co, Ni, Mo, or halogenated aluminum; or Ti, V, Zr, Ge, Ga, Sn, Si or In with an oxygen atom, a halogen atom, or a hydroxy group bonded thereto.

3. The electrophotographic photoreceptor of claim 1 or 2, wherein the CTM in the charge transporting layer is a hole transporting material (HTM).

4. The electrophotographic photoreceptor of any one of claims 1 to 3, further comprising:
an ETM in the charge transporting layer.

5. An electrophotographic photoreceptor, comprising:
an electrically conductive substrate; and
a photosensitive layer formed on the electrically conductive substrate, the photosensitive layer being a charge generating-transporting layer including a charge generating material (CGM), a hole transporting material (HTM), and a diphenoquinone-based compound including an oxadiazolene group of Formula 1 below as an electron transporting material (ETM), dispersed or dissolved within a binder resin: 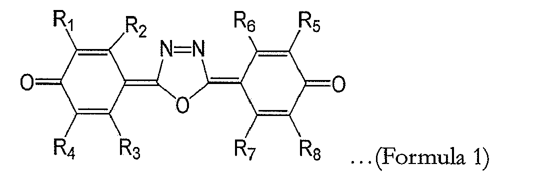
wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

6. The electrophotographic photoreceptor of claim 5, wherein the CGM is selected from the group consisting of a metal-free phthalocyanine-based compound represented by Formula 2 below, a metallic phthalocyanine-based compound represented by Formula 3 below, and mixtures thereof: 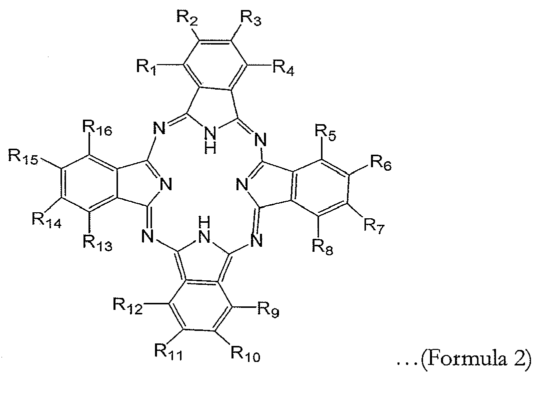 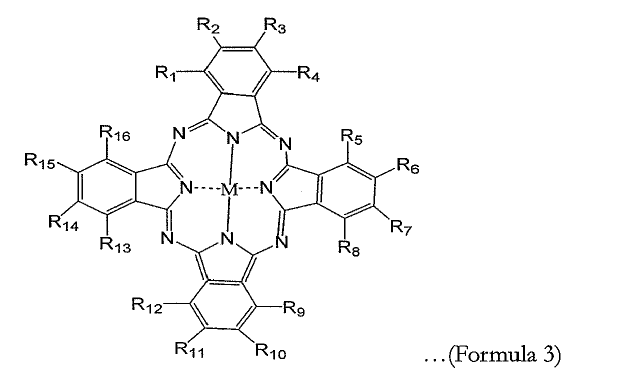 wherein R₁ to R₁₆ are each independently selected from a hydrogen atom, a halogen atom, a nitro group, a C₁-C₂₀ substituted or unsubstituted alkyl group and a C₁-C₂₀ substituted or unsubstituted alkoxy group, and M is Cu, Fe, Mg, Sn, Pb, Zn, Co, Ni, Mo or halogenated aluminum; or Ti, V, Zr, Ge, Ga, Sn, Si or In with an oxygen atom, a halogen atom, or a hydroxy group bonded thereto.

7. The electrophotographic photoreceptor of claim 5 or 6, wherein the photosensitive layer further comprises:
an electron-accepting material.

8. An electrophotographic imaging apparatus, comprising:
an electrophotographic photoreceptor, wherein the electrophotographic photoreceptor comprises:
an electrically conductive substrate;
a charge generating layer formed on the electrically conductive substrate, the charge generating layer including a charge generating material (CGM) and an electron transporting material (ETM) having a diphenoquinone-based compound comprising an oxadiazolene group represented by Formula 1 below, dispersed or dissolved within a binder resin; and
a charge transporting layer formed on the charge generating layer, the charge transporting layer including a charge transporting material (CTM) dispersed or dissolved within a binder resin: 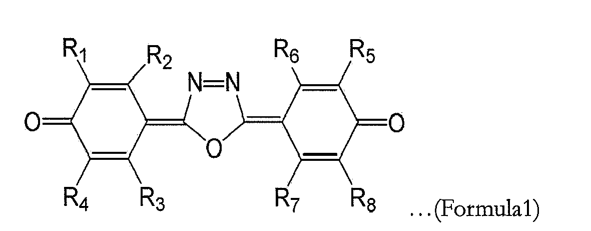
wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

9. The electrophotographic imaging apparatus of claim 8, wherein the CGM is selected from the group consisting of a metal-free phthalocyanine-based compound represented by Formula 2 below, a metallic phthalocyanine-based compound represented by Formula 3 below, and mixtures thereof: 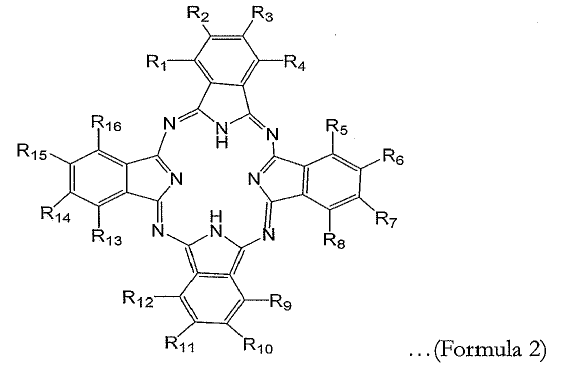 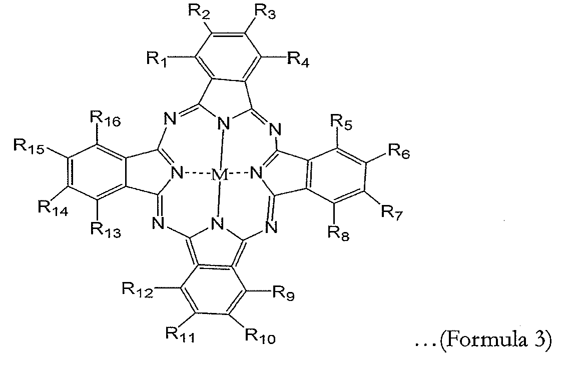 wherein R₁ to R₁₆ are each independently selected from a hydrogen atom, a halogen atom, a nitro group, a C₁-C₂₀ substituted or unsubstituted alkyl group and a C₁-C₂₀ substituted or unsubstituted alkoxy group, and M is Cu, Fe, Mg, Sn, Pb, Zn, Co, Ni, Mo or halogenated aluminum; or Ti, V, Zr, Ge, Ga, Sn, Si or In with an oxygen atom, a halogen atom, or a hydroxy group bonded thereto.

10. The electrophotographic imaging apparatus of claim 8 or 9, wherein the CTM in the charge transporting layer is a hole transporting material (HTM).

11. The electrophotographic imaging apparatus of any one of claims 8 to 10, further comprising:
an ETM in the charge transporting layer.

12. An electrophotographic imaging apparatus, comprising:
an electrophotographic photoreceptor, the electrophotographic photoreceptor including an electrically conductive substrate; and
a photosensitive layer formed on the electrically conductive substrate, the photosensitive layer being a charge generating-transporting layer including a charge generating material (CGM), an HTM, and a diphenoquinone-based compound including an oxadiazolene group of Formula 1 below as an electron transporting material (ETM), dispersed or dissolved within a binder resin: 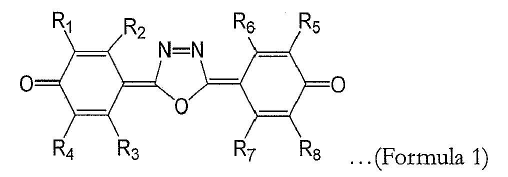
wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.

13. The electrophotographic imaging apparatus of claim 12, wherein the CGM is selected from the group consisting of a metal-free phthalocyanine-based compound represented by Formula 2 below, a metallic phthalocyanine-based compound represented by Formula 3 below, and mixtures thereof: 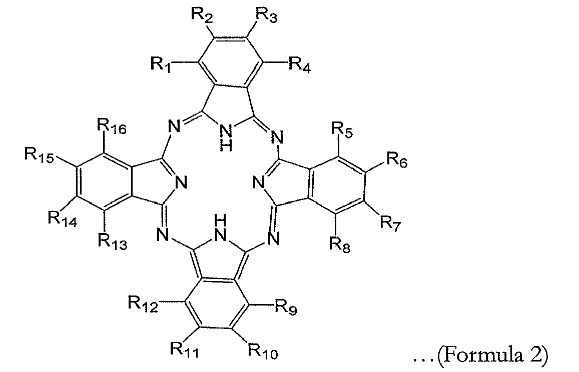 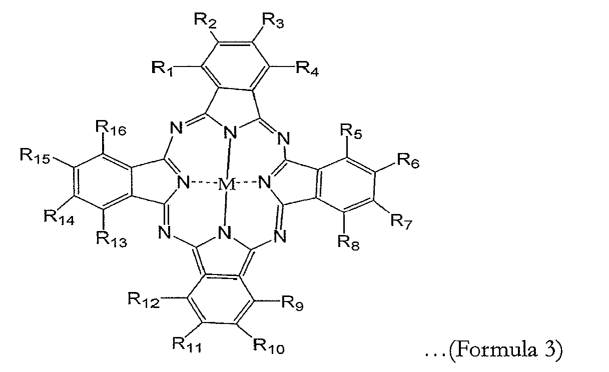 wherein R₁ to R₁₆ are each independently selected from a hydrogen atom, a halogen atom, a nitro group, a C₁-C₂₀ substituted or unsubstituted alkyl group and a C₁-C₂₀ substituted or unsubstituted alkoxy group; and M is Cu, Fe, Mg, Sn, Pb, Zn, Co, Ni, Mo or halogenated aluminum; or Ti, V, Zr, Ge, Ga, Sn, Si or In with an oxygen atom, a halogen atom, or a hydroxy group bonded thereto.

14. The electrophotographic photoreceptor of claim 12 or 13, wherein the photosensitive layer further comprises:
an electron-accepting material.

15. An electrophotographic photoreceptor for use in an electrophotographic imaging apparatus, the electrophotographic photoreceptor comprising:
a photosensitive layer, the photosensitive layer being a charge generating-transporting layer including a charge generating material (CGM), a hole transporting material (HTM), and a diphenoquinone-based compound including an oxadiazolene group of Formula 1 below as an electron transporting material (ETM), dispersed or dissolved within a binder resin: 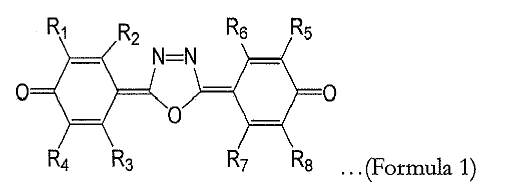
wherein R₁, R₂, R₃, R₄, R₅, R₆, R₇ and R₈ are each independently selected from the group consisting of a hydrogen atom, a C₁-C₂₀ substituted or unsubstituted alkyl group, a C₁-C₂₀ substituted or unsubstituted alkoxy group, a C₆-C₃₀ substituted or unsubstituted aryl group, a C₇-C₃₀ substituted or unsubstituted aralkyl group, a halogen atom, a nitro group, a cyano group, and a sulfonic acid group.
